# EUROPEAN PATENT SPECIFICATION

(11) **EP 1 085 568 B1**
(45) Date of publication and mention of the grant of the patent: **07.07.2004**
(21) Application number: 99830586.6
(22) Date of filing: 17.09.1999
(51) Int. Cl.: H01L 21/60

(54) **Method for the electrical and mechanical interconnection of microelectronic components**
Verfahren für die elektrische und mechanische Verbindung von mikroelektronischen Komponenten
Procédé de réalisation d'une connexion électrique et méchanique entre des composants micro-electroniques

(43) Date of publication of application: 21.03.2001
(73) Proprietor: STMicroelectronics S.r.l., 20041 Agrate Brianza (Milano) (IT)
(72) Inventor: Murari, Bruno, 20052 Monza (Milano) (IT); Mastromatteo, Ubaldo, 20010 Cornaredo (Milano) (IT); Vigna, Benedetto, 85100 Potenza (IT)
(74) Representative: Maccalli, Marco

(56) References cited:
- EP-A- 0 913 921
- US-A- 5 920 978
- PATENT ABSTRACTS OF JAPAN vol. 018, no. 617 (E-1634), 24 November 1994 (1994-11-24) -& JP 06 236886 A (NEC CORP), 23 August 1994 (1994-08-23)
- PATENT ABSTRACTS OF JAPAN vol. 017, no. 238 (E-1363), 13 May 1993 (1993-05-13) -& JP 04 364742 A (SEIKO EPSON CORP), 17 December 1992 (1992-12-17)
- PATENT ABSTRACTS OF JAPAN vol. 011, no. 237 (E-528), 4 August 1987 (1987-08-04) -& JP 62 049639 A (SHARP CORP), 4 March 1987 (1987-03-04)

## Description

The present invention relates to the microelectronics field in general and, more particularly, to the field of multi-component microelectronic systems such as, for example, micro-electromechanical systems ("MEMS") in which two or more component parts of the system have to be electrically and/or mechanically interconnected.

It is known that, in the production of complex MEMS comprising several mechanically and/or electrically interconnected subsystems, the greatest difficulties are encountered during the interfacing and connection of the various subsystems.

For example, in hard-disk reading/writing units having micrometric actuation for the fine positioning of the reading/writing transducers (heads or sliders), it is necessary to interconnect the suspension, the micro-actuator, and the slider. The slider is fixed to the rotor of the micro-actuator, usually by being glued to a support plate which in turn is anchored to the rotor. The slider is also soldered at several points to flexible mechanical connection elements (also called springs) suspended above the rotor and connected in a cantilevered manner to the static part of the micro-actuator. Finally, the electrical terminals of the slider (of which there are at least four, two for reading and two for writing) are soldered to further flexible electrical connection elements (springs) also suspended above the rotor and connected in a cantilevered manner to the static portion of the micro-actuator.

The soldering operations are generally performed by the "ball bonding" technique and are extremely delicate operations. Moreover, if the micro-actuator is found to be faulty during the subsequent functional testing stage, the entire micro-electromechanical system has to be rejected since the functioning components of the system cannot easily be disconnected for reuse.

Similar problems arise in multichip systems in which two (or more) chips, each incorporating a respective integrated circuit, have to be mechanically and electrically interconnected in predetermined regions so as to form a single microelectronic system. In this case also, in addition to the difficulty of the soldering operation, production output is greatly penalized by the fact that it is impossible to disconnect faulty chips from functioning ones in order to be able to reuse the latter.

Patent Abstract of Japan vol.018, no. 617 (E-1634), 24 November 1994 with reference to the patent JP 06 236886 discloses a method for joining a bump pillar to a bump forming electrode in a semiconductor device. The method comprises a step of supplying a current in resistors to release heating and causing the fusion of the bumps and their joining.
Patent Abstract of Japan vol.011, no 237 (E-528), 4 August 1987 with reference to JP 62 049639 and Patent Abstract of Japan vol.017, no 238 (E-1363), 13 May 1993 with reference to JP 04 36474 describe connection methods in a cellular battery and in a semiconductor device, respectively, employing steps of supplying electric current to a resistor for causing the soldering and the joining of two components.

In view of the prior art described, an object of the present invention is to provide a method for the electrical and/or mechanical connection of components parts of a microelectronic system which overcomes all of the problems mentioned.

According to the present invention, this object is achieved by a method as defined by the appended claim 1 and a structure as defined in claim 14.

The characteristics and advantages of the present invention will become clear from the following detailed description of a possible practical embodiment, illustrated purely by way of non-limiting example in the appended drawings, in which:
Figure 1, which relates to a first practical embodiment of the invention, is a schematic axonometric view of a unit comprising a hard-disk reading/writing transducer and the respective micro-actuator,
Figure 2 is an axonometric view showing, on an enlarged scale, an element for electrical connection to the reading/writing transducer shown in Figure 1,
Figure 3 is a section taken in the plane of the line III-III of Figure 2,
Figure 4, which relates to a variant of the first embodiment of the invention, is a plan view of a unit comprising a reading/writing transducer and the respective micro-actuator, showing electrical connection elements and mechanical connection elements,
Figure 5 is a schematic, axonometric view of two chips of a multichip system before their interconnection, and
Figure 6 is a view showing a detail of Figure 5 in section.

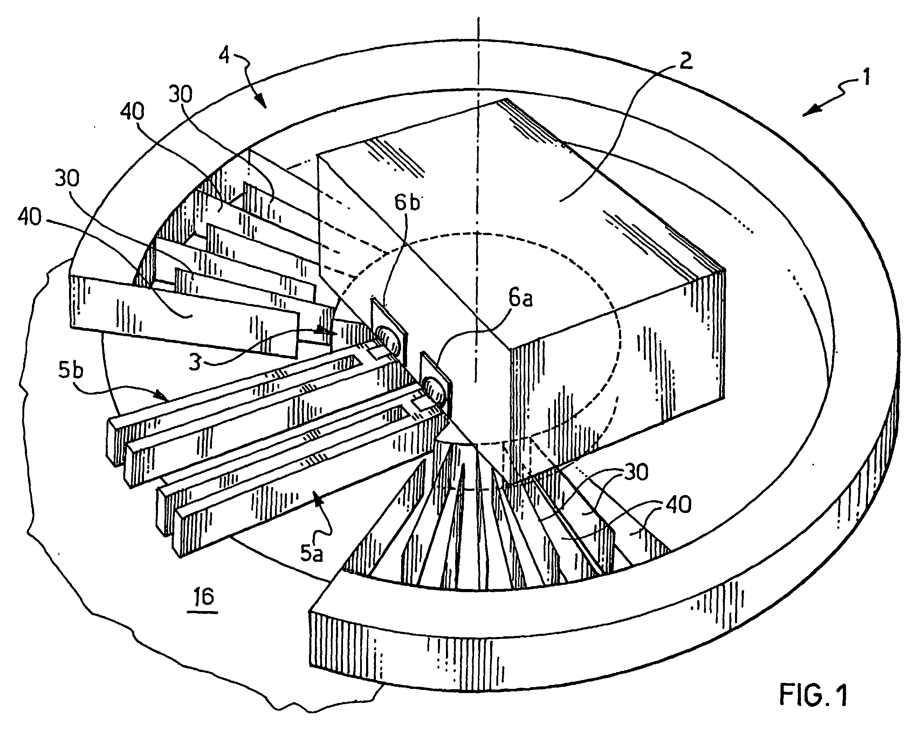

With reference to Figure 1, this is an axonometric view showing schematically a micro-actuator 1 of the type used in a hard-disk reading/writing unit for the fine positioning of a reading/writing transducer (head or "slider") 2.

The micro-actuator 1 in the embodiment shown is an electrostatic micro-actuator comprising an inner rotor 3 and an outer stator 4, both made of polysilicon. Movable electrodes 30 projecting radially from the periphery of the rotor 3 are interdigitated with fixed electrodes 40 which project radially from the stator 4 towards the rotor 3. A micro-actuator of this type is described, for example, in the Applicant's European patent application No. EP 0913921, to which reference should be made for a detailed explanation.

The slider 2 is fixed to the rotor 3, typically by being glued to a support plate (not shown for greater clarity of the drawings) which in turn is anchored to the rotor 3.

Two suspended and flexible electrical connection elements 5a, 5b are visible in Figure 1 and extend from the outer periphery of the micro-actuator 1, in a circular-sector-shaped region in which the stator and the rotor are interrupted, as far as respective electrical terminals 6a, 6b of the slider 2.

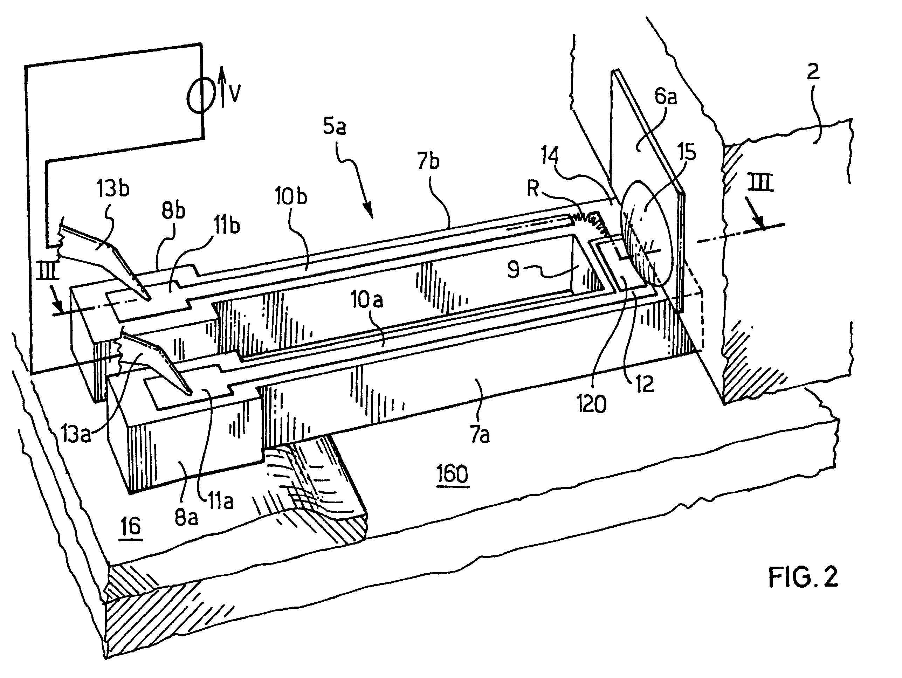

As can best be seen in the enlarged view of Figure 2, each electrical connection element comprises a pair of substantially parallel bars 7a, 7b anchored in a cantilevered manner to a layer of insulating material 16 and suspended above an underlying semiconductor substrate 160e. The bars 7a, 7b are made, for example, from the same polysilicon layer from which the rotor and the stator are made.

Each bar 7a, 7b has an enlarged head 8a, 8b, anchored to the layer 16, and the end of the bar remote from the head is joined to the other bar of the pair by means of a crosspiece 9. A pad 11a, 11b of conductive material, for example, aluminium or copper, is formed on each bar 7a, 7b on the head 8a, 8b, and a respective track 10a, 10b, also made of conductive material, also, for example, aluminium or copper, extends from the pad. The track 10b terminates substantially in the region of the crosspiece 9, whereas the track 10a extends to merge with a pad 12 of conductive material, for example, aluminium or copper, gold-plated in the soldering area (as indicated 120) and formed on the crosspiece 9 substantially beneath the electrical terminal 6a, 6b of the slider 2.

The pads 11a, 11b, the tracks 10a, 10b, the pad 12, and the portion 14 of the crosspiece 9 between the end of the pad 12 and the end of the track 10b form a conductive path the overall resistance of which is concentrated substantially in the polysilicon portion 14 which has greater resistivity than aluminium or copper, as shown schematically by the resistor R.

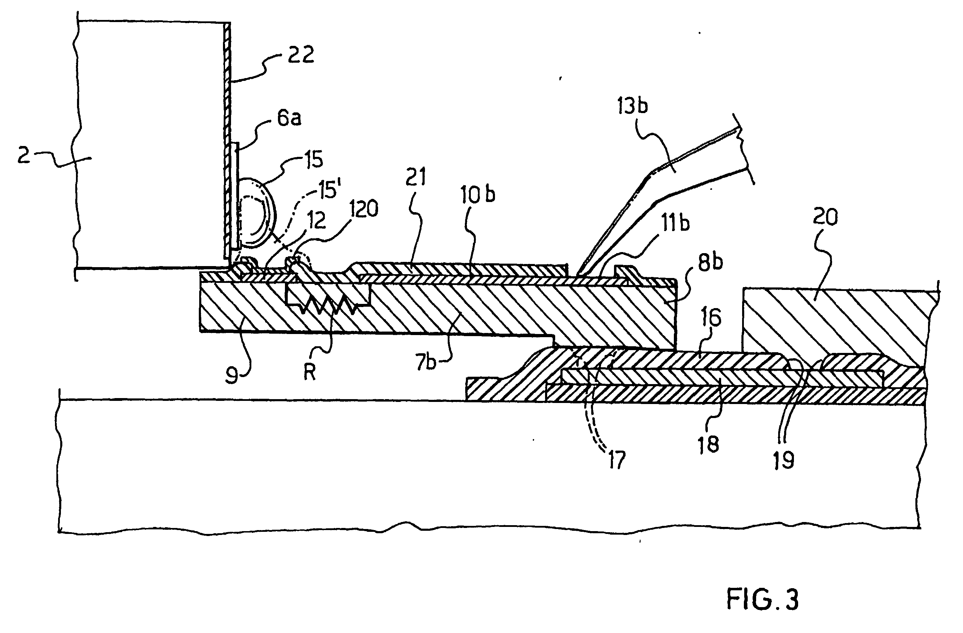

As shown in greater detail in Figure 3, the bar 7b is anchored in a cantilevered manner to the insulating layer 16 which, for example, is made of silicon oxide. The bar 7a, on the other hand, contacts, through an opening 17 in the oxide layer 16, an underlying polysilicon layer 18 which extends out of the micro-actuator and is contacted, through a further opening 19 in the oxide layer 16, by a further polysilicon bar 20 which extends substantially as far as the periphery of the chip containing the micro-actuator for the soldering of electrical wires which will be connected to the electrical terminals 6a, 6b of the slider. The tracks 10a, 10b are covered by a layer of passivating material 21 which has openings on the pad 12 to permit soldering to the electrical terminal 6a, 6b of the slider, and on the pads 11a, 11b to permit contact by electrical-energy supply probes 13a, 13b.

The electrical terminals 6a, 6b of the slider are formed on a dielectric layer 22 which thermally insulates the body of the slider.

In order to solder the terminals of the slider, the two probes 13a, 13b are placed on the pads 11a, 11b and an electric pulse (for example, a voltage V as shown schematically in Figure 2) is applied to the probes so as to close the electrical circuit. The current which flows in the circuit brings about localized heating by the Joule effect in the region of the resistor R, that is, the portion of the circuit having greater resistance. This heating melts a spot 15 of soldering material, for example, a lead/tin alloy previously applied to the electrical terminal 6a, 6b of the slider; as the spot 15 melts, it drops onto the pad 12 (as indicated schematically 15' in chain line). When the voltage supply to the electric circuit is interrupted, the molten soldering material sets, thus bringing about soldering of the slider terminal to the pad 12 and hence the electrical connection to the pad 11a.

In other words, the circuit portion with greater resistance R acts as an integrated local Joule-effect micro-heater. The heat generated by the micro-heater by the Joule effect is utilized to melt the solder 15. The micro-heater is activated by the application of a suitable voltage upstream and downstream thereof, that is, by the supply of electrical energy thereto.

Clearly, variants and/or additions may be applied to the embodiment described and illustrated above.

For example, instead of providing pairs of polysilicon bars, the electric soldering circuit may be formed on a single bar of sufficient width, on which the two pads 11a, 11b for the probes 13a, 13b, the two tracks 10a, 10b, and the pad 12 may be formed.

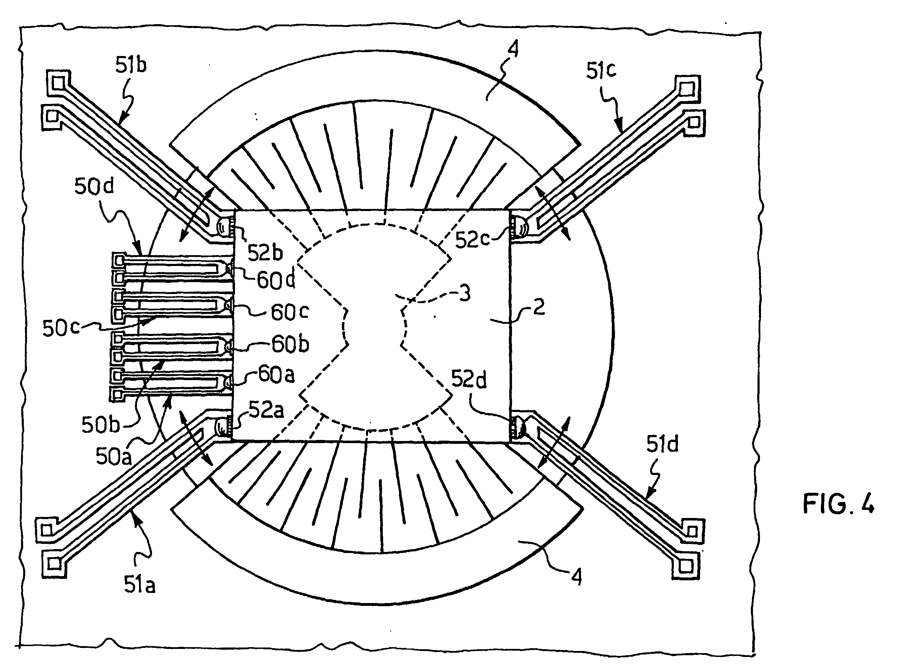

Moreover, the bars 7a, 7b and the crosspiece 14 could be made of materials other than polysilicon, possibly even of insulating material, and the micro-heaters could be formed on the bars by the deposition of a refractory and sufficiently resistive material on the bars, instead of being constituted by respective portions of the bars. The plan view of Figure 4 shows a variant of the embodiment described above in which the method according to the invention is used not only for soldering electrical terminals 60a - 60d of the slider 2 to respective electrical connection elements 50a - 50d similar to the elements 5a, 5b of Figure 1 but also for soldering points 52a - 52d for the mechanical anchorage of the slider 2 to respective flexible elements (springs) 51a - 51d for the mechanical connection of the slider to the chip containing the micro-actuator. Both the electrical connection springs 50a - 50d and the mechanical connection springs 51a - 51d are formed as shown in Figures 2 and 3 and described with reference thereto. The points 52a - 52d for the mechanical anchorage of the slider are soldered to the respective mechanical connection springs 51a - 51d in the manner described above.

By virtue of the present invention, the soldering operation for the electrical and/or mechanical interconnection of the slider to the micro-actuator poses no problems and there is no risk of damaging the delicate structure of the micro-actuator.

The method according to the present invention may also advantageously be used for unsoldering the slider from the micro-actuator, for example, if faults in the micro-actuator or in the circuitry integrated in the micro-actuator chip or in the slider are detected during testing. In fact it is possible, by proceeding exactly as described for the soldering, to unsolder the slider and to replace solely the faulty component with a functioning one. The need to discard the entire microelectronic system because of a fault which affects a single component is thus avoided.

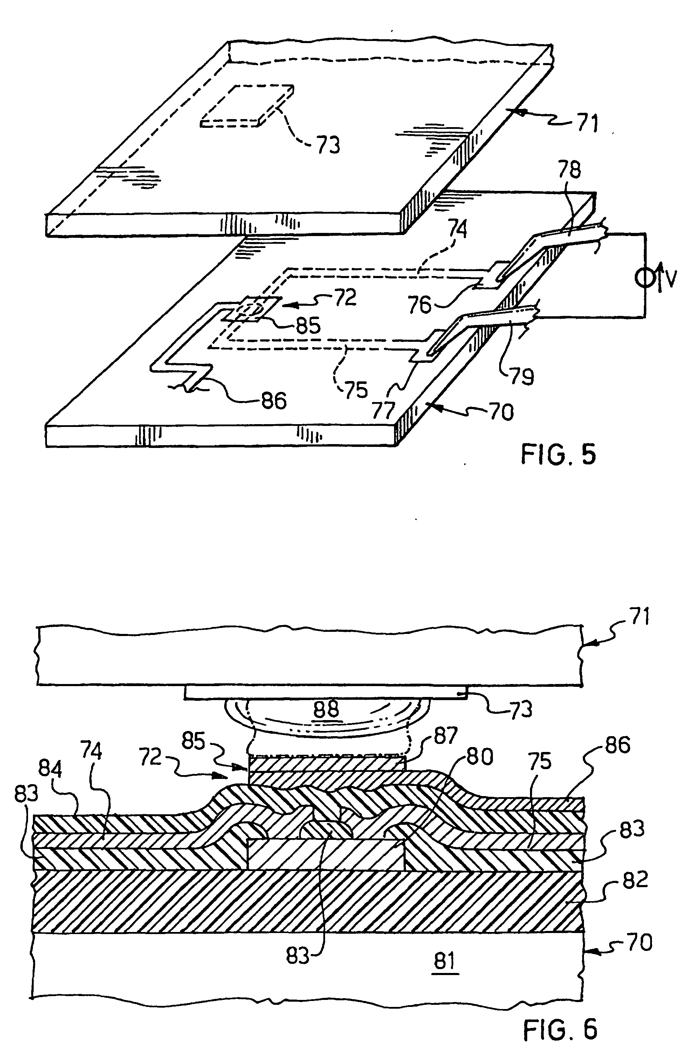

Figures 5 and 6 show schematically an example for the electrical and/or mechanical interconnection of two chips 70, 71, each incorporating respective integrated circuits, to form a multichip system.

Local Joule-effect micro-heaters 72, incorporated in the chip 70 in positions corresponding to those of soldering pads 73 of the chip 71, comprise resistive elements connected in an electrical circuit comprising a pair of tracks 74, 75 of conductive material, for example, aluminium or copper, terminating in respective pads 76, 77 on which probes 78, 79 can be placed.

As shown in Figure 6, the micro-heater 72 comprises a resistive element 80 of refractory material of sufficient resistivity, for example, polysilicon, separated from a semiconductor substrate 81 of the chip 70 by a dielectric layer 82 of low thermal conductivity (for example silicon oxide). The two tracks 74, 75 contact the resistive element 80 at two respective points through respective openings in an insulating layer 83. A dielectric layer 84 covers the resistive element 80 and the tracks 74, 75. A soldering pad 85 formed above the dielectric layer 84 comprises an enlarged head of a track 86, for example, of aluminium or copper, for electrical interconnection between the two chips 70, 71. A layer of gold 87 is preferably formed on the pad 85.

Spots 88 of solder, typically a lead/tin alloy, are applied to the pads 73 of the chip 71 or, may equally well be applied to the corresponding pads 85 of the chip 70. The two chips are then brought together so as to bring the pads 73 adjacent the respective pads 85. The probes 78, 79 are placed on the pads 76, 77 and a voltage V is applied thereto. The current which flows in the electrical circuit formed by the tracks 74, 75 and by the resistive element 80 brings about heating of the resistive element 80 by the Joule effect. The heat thus produced causes the spot of solder 88 to melt, soldering the pads 73 and the pads 85 together, interconnecting the two chips 70, 71 electrically and mechanically.

In this example also, the soldering is achieved easily and does not pose problems of damage to the structures incorporated in the two chips. Moreover if, at a testing stage subsequent to the interconnection, it is found that one of the two chips suffers from malfunctioning, the two chips can be unsoldered and the faulty chip can be replaced by a new, functioning chip. The unsoldering is performed in exactly the same way as the soldering.

Clearly, variants of the example described and illustrated may also be provided. For example, the pad 85 could be connected in the conductive path 74-77 for the supply of electrical energy to the resistive element 80.

## Claims

1. A method for the mechanical and/or electrical interconnection of components of a micro-electromechanical system (1) comprising at least one first component (2) and one second component and at least one suspended flexible connection element (5a, 5b; 50a-50d, 51a-51d) fixed to a portion (16) of the second component and extending as far as the periphery of the first component (2), whereby
- at least one local Joule-effect micro-heater (R) is incorporated in the first component (2) or in the flexible connection element (5a, 5b; 50a-50d, 51a-51d) at a respective soldering point between the first component and the flexible connection element,
- a conductive path (11a, 10a, 12, 120, 14, 10b, 11b) is incorporated in the flexible connection element (5a, 5b; 50a-50d, 51a-51d) and connected to the micro-heater, at the soldering point, applying a mass of soldering alloy (15) and
- supplying electrical energy (V, 13a, 13b;) to the micro-heater by means of the conductive path so as to melt the mass of soldering alloy and thereby to solder the first component to the flexible connection element at the soldering point.

2. A method according to Claim 1, **characterized in that** the formation of the at least one local Joule-effect micro-heater comprises the formation of a resistive element (14) connected in the conductive path (11a, 10a, 12, 120, 14, 10b, 11b), the conductive path having a resistance substantially concentrated in the resistive element.

3. A method according to Claim 2, **characterized in that** the supply of energy to the micro-heater (R) comprises the application of a voltage (V) at two points (11a, 11b;) of the conductive path (11a, 10a, 12, 120, 14, 10b, 11b) upstream and downstream of the resistive element (14) in order to create a closed electrical circuit in which the resistive element is connected.

4. A method according to Claim 3, **characterized in that** it comprises the formation, at the two points (11a, 11b) of the conductive path (11a, 10a, 12, 120, 14, 10b, 11b), of first contact pads for respective micro-probes (13a, 13b) for supplying the voltage (V).

5. A method according to Claim 4, **characterized in that** it provides for the formation, , of a second pad (12, 120) at the soldering point for receiving the mass of melting solder (15; 88).

6. A method according to claim 5, **characterized in that** the second pad (12, 120) is connected in the conductive path (11a, 10a, 12, 14, 10b, 11b) so as to form the electrical interconnection between the flexible connection element (5a, 5b; 50a-50d, 51a-51d) and the first component (2), via the conductive path (11a, 10a, 12, 14, 10b, 11b).

7. A method according to any one of the preceding claims, **characterized in that** it provides, after a stage in which the micro-electro-mechanical system is tested and in which a faulty condition is identified in one of the components of the system, for electrical energy to be supplied to the at least one micro-heater in order to unsolder the first component and the flexible connection element of the system by means of the heat generated by the Joule effect, so that the faulty component can be replaced by a functioning component.

8. A method according to Claim 1, in which the micro-electromechanical system comprises a hard-disk reading/writing transducer (2) coupled to a rotor portion of a respective micro-actuator (1), the first component being the transducer (2) and the second component being a semiconductor chip in which the micro-actuator is incorporated.

9. A method according to Claim 8 in which the at least one flexible connection element (5a, 5b; 50a-50d, 51a-51d) is fixed in a cantilevered manner to a static portion of the micro-actuator and extends towards an electrical terminal (6a, 6b; 60a-60d) or an anchorage point (52a-52d) of the transducer (2).

10. A method according to Claim 9, **characterized in that** the flexible connection element (5a, 5b; 50a-50d, 51a-51d) is made of polycrystalline silicon, the conductive path (11a,10a, 12, 14, 10b,11b) is made of a material more conductive than polycrystalline silicon, and the resistive element (14) is a portion of the flexible element between a first portion (11a, 10a, 12) and a second portion (10b, 11b) of the conductive path.

11. A method according to Claim 10, **characterized in that** the conductive path (11a, 10a, 12, 10b, 11b) is made of metal on top of the flexible connection element (5a, 5b; 50a-50d, 51a-51d).

12. A method according to Claim 11, **characterized in that** the flexible connection element (5a, 5b; 50a-50d, 51a-51d) comprises a pair of substantially parallel bars (7a, 7b) anchored at respective enlarged first ends (8a, 8b) to the static portion of the micro-actuator (1) and joined together at the other end in the vicinity of the transducer (2) by a crosspiece (9), the contact pads (11a, 11b) for the probes (13a, 13b) being formed on the enlarged first ends of the bars, the conductive path comprising a first track (10a) formed on one (7a) of the two bars and a second track (10b) formed on the other (7b) of the two bars, the pad (12) being formed on the crosspiece, and the resistive element (14) being formed by a portion of the crosspiece.

13. A method according to any one of Claims 9 to 12, in which the flexible connection element is an element for electrical connection to a terminal (6a, 6b; 60a-60d) of the transducer, **characterized in that**, after the soldering of the pad (12), the first track (10a) and the contact pad (11a) are used for the electrical connection to the terminal of the transducer.

14. A structure for the electrical and/or mechanical interconnection of components of a micro-electro-mechanical system comprising at least one first component (2) and one second component, and at least one suspended flexible connection element (5a, 5b; 50a-50d, 51a-51d) fixed to a portion (16) of the second component and extending towards as far as the periphery of the first component (2),
**characterized in that** it comprises:
- at least one local Joule-effect micro-heater incorporated in one of the first component or in the flexible connection element at a respective soldering point between the first component and said flexible connection element, and
- a conductive path (11a, 10a, 12, 120, 14, 10b, 11b) incorporated in the flexible connection element (5a, 5b; 50a-50d, 51a-51d) and connected to the micro-heater and adapted to supply electrical energy to the micro-heater, and a mass of solder alloy joining the first component to the flexible connection element at the soldering point.

## Patentansprüche

1. Ein Verfahren für die mechanische und/oder elektrische Verbindung von Komponenten eines mikroelektromechanischen Systems (1), das zumindest eine erste Komponente (2) und eine zweite Komponente und zumindest ein flexibles Schwebeverbindungselement (5a, 5b; 50a-50d, 51a-51d) aufweist, das an einem Abschnitt (16) der zweiten Komponente befestigt ist und sich bis zu dem Umfang der ersten Komponente (2) erstreckt, wobei
- zumindest ein lokaler Joule-Effekt-Mikroheizer (R) in der ersten Komponente (2) oder in dem flexiblen Verbindungselement (5a, 5b; 50a-50d, 51a-51d) bei einem jeweiligen Lötpunkt zwischen der ersten Komponente und dem flexiblen Verbindungselement eingegliedert ist,
- ein leitfähiger Weg (11a, 10a, 12, 120, 14, 10b, 11b) in dem flexiblen Verbindungselement (5a, 5b; 50a-50d, 51a-51d) eingegliedert ist und mit dem Mikroheizer bei dem Lötpunkt verbunden ist, wobei eine Masse einer Lötlegierung (15) aufgebracht wird, und
- eine elektrische Energie (V, 13a, 13b;) zu dem Mikroheizer mittels des leitfähigen Wegs geliefert wird, um die Masse einer Lötlegierung zu schmelzen und dadurch die erste Komponente bei dem Lötpunkt an das flexible Verbindungselement zu löten.

2. Ein Verfahren gemäß Anspruch 1, **dadurch gekennzeichnet, daß** die Bildung des zumindest einen lokalen Joule-Effekt-Mikroheizers die Bildung eines resistiven Elements (14) aufweist, das in den leitfähigen Weg (11a, 10a, 12, 120, 14, 10b, 11b) geschaltet ist, wobei der leitfähige Weg einen Widerstand aufweist, der im wesentlichen in dem resistiven Element konzentriert ist.

3. Ein Verfahren gemäß Anspruch 2, **dadurch gekennzeichnet, daß** die Energieversorgung zu dem Mikroheizer (R) die Anlegung einer Spannung V bei zwei Punkten (11a, 11b;) des leitfähigen Wegs (11a, 10a, 12, 120, 14, 10b, 11b) vorgeschaltet und nachgeschaltet zu dem resistiven Element (14) aufweist, um eine geschlossene elektrische Schaltung zu erzeugen, in die das resistive Element geschaltet ist.

4. Ein Verfahren gemäß Anspruch 3, **dadurch gekennzeichnet, daß** dasselbe die Bildung von ersten Kontaktanschlußflächen für jeweilige Mikrosonden (13a, 13b) zu einem Liefern der Spannung V bei den zwei Punkten (11a, 11b) des leitfähigen Wegs (11a, 10a, 12, 120, 14, 10b, 11b) aufweist.

5. Ein Verfahren gemäß Anspruch 4, **dadurch gekennzeichnet, daß** dasselbe die Bildung einer zweiten Anschlußfläche (12, 120) bei dem Lötpunkt zum Empfangen der Masse von Schmelzlötmittel (15; 88) vorsieht.

6. Ein Verfahren gemäß Anspruch 5, **dadurch gekennzeichnet, daß** die zweite Anschlußfläche (12, 120) in den leitfähigen Weg (11a, 10a, 12, 14, 10b, 11b) geschaltet ist, um die elektrische Verbindung zwischen dem flexiblen Verbindungselement (5a, 5b; 50a-50d, 51a-51d) und der ersten Komponente (2) über den leitfähigen Weg (11a, 10a, 12, 14, 10b, 11b) zu bilden.

7. Ein Verfahren gemäß einem der vorhergehenden Ansprüche, **dadurch gekennzeichnet, daß** dasselbe, nach einer Stufe, bei der das mikroelektromechanische System getestet wird und bei der eine fehlerhafte Bedingung bei einer der Komponenten des Systems identifiziert wird, eine elektrische Energie bereitstellt, die zu dem zumindest einen Mikroheizer geliefert werden soll, um die erste Komponente und das flexible Verbindungselement des Systems mittels der durch den Joule-Effekt erzeugten Wärme zu entlöten, so daß die fehlerhafte Komponente durch eine funktionierende Komponente ersetzt werden kann.

8. Ein Verfahren gemäß Anspruch 1, bei dem das mikroelektromechanische System einen Festplatte-Lese/Schreiben-Wandler (2) aufweist, der mit einem Rotor-Abschnitt eines jeweiligen Mikrobetätigers (1) gekoppelt ist, wobei die erste Komponente der Wandler (2) ist und die zweite Komponente ein Halbleiterchip ist, in dem der Mikrobetätiger eingegliedert ist.

9. Ein Verfahren gemäß Anspruch 8, bei dem das zumindest eine flexible Verbindungselement (5a, 5b; 50a-50d, 51a-51d) auf eine freitragende Weise an einem statischen Abschnitt des Mikrobetätigers befestigt ist und sich zu einem elektrischen Anschluß (6a, 6b; 60a-60d) oder einem Verankerungspunkt (52a-52d) des Wandlers (2) erstreckt.

10. Ein Verfahren gemäß Anspruch 9, **dadurch gekennzeichnet, daß** das flexible Verbindungselement (5a, 5b; 50a-50d, 51a-51d) aus polykristallinem Silizium hergestellt ist, wobei der leitfähige Weg (11a, 10a, 12, 14, 10b, 11b) aus einem leitfähigeren Material als polykristallinem Silizium hergestellt ist und das resistive Element (14) ein Abschnitt des flexiblen Elements zwischen einem ersten Abschnitt (11a, 10a, 12) und einem zweiten Abschnitt (10b, 11b) des leitfähigen Wegs ist.

11. Ein Verfahren gemäß Anspruch 10, **dadurch gekennzeichnet, daß** der leitfähige Weg (11a, 10a, 12, 10b, 11b) aus einem Metall auf dem flexiblen Verbindungselement (5a, 5b; 50a-50d, 51a-51d) hergestellt ist.

12. Ein Verfahren gemäß Anspruch 11, **dadurch gekennzeichnet, daß** das flexible Verbindungselement (5a, 5b; 50a-50d, 51a-51d) ein Paar von im wesentlichen parallelen Stäben (7a, 7b) aufweist, die an jeweiligen vergrößerten ersten Enden (8a, 8b) an dem statischen Abschnitt des Mikrobetätigers (1) verankert sind und an dem anderen Ende in der Nähe des Wandlers (2) durch einen Steg (9) miteinander verbunden sind, wobei die Kontaktanschlußflächen (11a, 11b) für die Sonden (13a, 13b) an den vergrößerten ersten Enden der Stäbe gebildet sind, wobei der leitfähige Weg eine erste Spur (10a), die an einem (7a) der zwei Stäbe gebildet ist, und eine zweite Spur (10b) aufweist, die an dem anderen (7b) der zwei Stäbe gebildet ist, wobei die Anschlußfläche (12) an dem Steg gebildet ist und wobei das resistive Element (14) durch einen Abschnitt des Stegs gebildet ist.

13. Ein Verfahren gemäß einem der Ansprüche 9 bis 12, bei dem das flexible Verbindungselement ein Element zu einer elektrischen Verbindung mit einem Anschluß (6a, 6b; 60a-60d) des Wandlers ist, **dadurch gekennzeichnet, daß** nach dem Löten der Anschlußfläche (12) die erste Spur (10a) und die Kontaktanschlußfläche (11a) für die elektrische Verbindung mit dem Anschluß des Wandlers verwendet werden.

14. Eine Struktur für die elektrische und/oder mechanische Verbindung von Komponenten eines mikroelektromechanischen Systems, das zumindest eine erste Komponente (2) und eine zweite Komponente und zumindest ein flexibles Schwebeverbindungselement (5a, 5b; 50a-50d, 51a-51d) aufweist, das an einem Abschnitt (16) der zweiten Komponente befestigt ist und sich bis zu dem Umfang der ersten Komponente (2) hin erstreckt,
**dadurch gekennzeichnet, daß** dieselbe folgende Merkmale aufweist:
- zumindest einen lokalen Joule-Effekt-Mikroheizer, der in einem der ersten Komponente oder in dem flexiblen Verbindungselement bei einem jeweiligen Lötpunkt zwischen der ersten Komponente und dem flexiblen Verbindungselement eingegliedert ist, und
- einen leitfähigen Weg (11a, 10a, 12, 120, 14, 10b, 11b), der in dem flexiblen Verbindungselement (5a, 5b; 50a-50d, 51a-51d) eingegliedert ist und mit dem Mikroheizer verbunden ist und angepaßt ist, um eine elektrische Energie zu dem Mikroheizer zu liefern, und
- eine Masse einer Lötmittellegierung, die die erste Komponente mit dem flexiblen Verbindungselement bei dem Lötpunkt verbindet.

## Revendications

1. Procédé de réalisation d'une connexion électrique et mécanique entre des composants d'un système micro-électromécanique (1) comprenant au moins un premier composant (2) et un second composant et au moins un élément de connexion souple suspendu (5a, 5b ; 50a - 50d, 51a - 51d) fixé à une partie (16) du second composant et s'étendant jusque la périphérie du premier composant (2), grâce à quoi
- au moins un micro-dispositif de chauffage à effet Joule local (R) est incorporé dans le premier composant (2) ou dans l'élément de connexion souple (5a, 5b ; 50a - 50d, 51a - 51d) au niveau d'un point de soudure respectif entre le premier composant et l'élément de connexion souple,
- un chemin conducteur (11a, 10a, 12, 120, 14, 10b, 11b) est incorporé dans l'élément de connexion souple (5a, 5b ; 50a - 50d, 51a - 51d) et connecté au micro-dispositif de chauffage, au niveau du point de soudure, en appliquant une masse d'alliage de soudure (15) qui est fondue par la chaleur dégagée par le micro-dispositif de chauffage (R), et
- une fourniture d'énergie électrique (V, 13a, 13b ;) au micro-dispositif de chauffage à l'aide du chemin conducteur afin de faire fondre la masse de l'alliage de soudure et de souder de ce fait le premier composant à l'élément de connexion souple au niveau du point de soudure.

2. Procédé selon la revendication 1, **caractérisé en ce que** la formation de l'au moins un micro-dispositif de chauffage à effet Joule local comprend la formation d'un élément résistif (14) connecté dans le chemin conducteur (11a, 10a, 12, 120, 14, 10b, 11b), le chemin conducteur possédant une résistance sensiblement concentrée dans l'élément résistif.

3. Procédé selon la revendication 2, **caractérisé en ce que** la fourniture d'énergie au micro-dispositif de chauffage (R) comprend l'application d'une tension (V) en deux points (11a, 11b ;) du chemin conducteur (11a, 10a, 12, 120, 14, 10b, 11b) en amont et en aval de l'élément résistif (14) afin de créer un circuit électrique fermé dans lequel l'élément résistif est connecté.

4. Procédé selon la revendication 3, **caractérisé en ce qu'**il comprend la formation, au niveau des deux points (11a, 11b) du chemin conducteur (11a, 10a, 12, 120, 14, 10b, 11b), de premières plages de contact pour des micro-sondes respectives (13a, 13b) pour fournir la tension (V).

5. Procédé selon la revendication 4, **caractérisé en ce qu'**il fournit la formation d'une seconde plage de contact (12, 120) au niveau du point de soudure pour recevoir la masse de la soudure de fusion (15 ; 88).

6. Procédé selon la revendication 5, **caractérisé en ce que** la seconde plage de contact (12, 120) est connectée dans le chemin conducteur (11a, 10a, 12, 14, 10b, 11b) afin de former la connexion électrique entre l'élément de connexion souple (5a, 5b ; 50a - 50d, 51a - 51d) et le premier composant (2), par l'intermédiaire du chemin conducteur (11a, 10a, 12, 14, 10b, 11b).

7. Procédé selon l'une quelconque des revendications précédentes, **caractérisé en ce qu'**il fournit, après une étape dans laquelle le système micro-électromécanique est vérifié et dans laquelle une condition de défaut est identifiée dans l'un des composants du système, une énergie électrique à fournir à l'au moins un micro-dispositif de chauffage afin de dessouder le premier composant et l'élément de connexion souple du système au moyen de la chaleur dégagée par effet Joule, de telle sorte que le composant défectueux peut être remplacé par un composant en bon état de fonctionnement.

8. Procédé selon la revendication 1, dans lequel le système micro-électromécanique comprend un transducteur de lecture / écriture de disque dur (2) couplé à une partie de rotor d'un micro-actionneur respectif (1), le premier composant étant le transducteur (2) et le second composant étant une puce de semiconducteur dans laquelle le micro-actionneur est incorporé.

9. Procédé selon la revendication 8, dans laquelle l'au moins un élément de connexion souple (5a, 5b ; 50a - 50d, 51a - 51d) est fixé d'une façon en porte-à-faux à une partie statique du micro-actionneur et s'étend vers une borne électrique (6a, 6b ; 60a - 60d) ou un point d'ancrage (52a - 52d) du transducteur (2).

10. Procédé selon la revendication 9, **caractérisé en ce que** l'élément de connexion souple (5a, 5b ; 50a - 50d, 51a - 51d) est réalisé en silicium polycristallin, le chemin conducteur (11a, 10a, 12, 14, 10b, 11b) est réalisé dans un matériau plus conducteur que le silicium polycristallin, et l'élément résistif (14) est une partie de l'élément souple entre une première partie (11a, 10a, 12) et une seconde partie (lOb, 11b) du chemin conducteur.

11. Procédé selon la revendication 10, **caractérisé en ce que** le chemin conducteur (11a, 10a, 12, 10b, 11b) est réalisé en métal au sommet de l'élément de connexion souple (5a, 5b ; 50a - 50d, 51a - 51d).

12. Procédé selon la revendication 11, **caractérisé en ce que** l'élément de connexion souple (5a, 5b ; 50a - 50d, 51a - 51d) comprend une paire de barres sensiblement parallèles (7a, 7b) ancrées au niveau des premières extrémités agrandies respectives (8a, 8b) à la partie statique du micro-actionneur (1) et reliées ensemble au niveau de l'autre extrémité à proximité du transducteur (2) par une entretoise (9), les plages de contact (11a, 11b) des sondes (13a, 13b) étant formées sur les premières extrémités agrandies des barres, le chemin conducteur comprenant une première piste (10a) formée sur l'une (7a) des deux barres et une seconde piste (10b) formée sur l'autre (7b) des deux barres, la plage de contact (12) étant formée sur l'entretoise, et l'élément résistif (14) étant formé par une partie de l'entretoise.

13. Procédé selon l'une quelconque des revendications 9 à 12, dans lequel l'élément de connexion souple est un élément destiné à une connexion électrique à une borne (6a, 6b ; 60a - 60d) du transducteur, **caractérisé en ce que**, après la soudure de la plage de contact (12), la première piste (10a) et la plage de contact (11a) sont utilisées pour réaliser la connexion électrique à la borne du transducteur.

14. Structure de connexion électrique et mécanique entre des composants d'un système micro-électromécanique comprenant au moins un premier composant (2) et un second composant, et au moins un élément de connexion souple suspendu (5a, 5b ; 50a - 50d, 51 a - 51d) fixé à une partie (16) du second composant et s'étendant vers jusque la périphérie du premier composant (2),
**caractérisé en ce que** il comprend :
- au moins un micro-dispositif de chauffage à effet Joule local incorporé dans l'un du premier composant ou de l'élément de connexion souple au niveau d'un point de soudure respectif entre le premier composant et ledit élément de connexion souple, et
- un chemin conducteur (11a, 10a, 12, 120, 14, 10b, 11b) incorporé dans l'élément de connexion souple (5a, 5b ; 50a - 50d, 51a - 51d) et connecté au micro-dispositif de chauffage et conçu pour fournir l'énergie électrique au micro-dispositif de chauffage, et une masse d'alliage de soudure reliant le premier composant à l'élément de connexion souple au niveau du point de soudure.
